# FASCICULE DE BREVET EUROPEEN

(11) **EP 1 511 884 B1**
(45) Date de publication et mention de la délivrance du brevet: **19.11.2008**
(21) Numéro de dépôt: 03752816.3
(22) Date de dépôt: 15.05.2003
(51) Int. Cl.: C30B 23/00, C30B 23/02

(54) **FORMATION DE CARBURE DE SILICIUM MONOCRISTALLIN**
VORRICHTUNG UND VERFAHREN ZUR HERSTELLUNG VON EINKRISTALLINEM SILIZIUMKARBID
FORMATION OF SINGLE-CRYSTAL SILICON CARBIDE

(30) Priorité: 15.05.2002 FR 0205967
(43) Date de publication de la demande: 09.03.2005
(73) Titulaire: CENTRE NATIONAL DE LA RECHERCHE SCIENTIFIQUE (CNRS), 75794 Paris Cedex 16 (FR); INSTITUT NATIONAL POLYTECHNIQUE DE GRENOBLE, 38031 Grenoble Cédex 1 (FR); Novasic, 73600 Moutiers (FR)
(72) Inventeur: MADAR, Roland, F-38320 Eybens (FR); PONS, Michel, F-38700 La Tronche (FR); BAILLET, Francis, F-38850 Paladru (FR); CHARPENTIER, Ludovic, F-38000 Grenoble (FR); PERNOT, Etienne, F-38360 Sassenage (FR); CHAUSSENDE, Didier, F-38690 FLACHERES (FR); TUROVER, Daniel, M., F-94160 Saint Mande (FR)
(74) Mandataire: de Beaumont, Michel
(86) Numéro de dépôt international: PCT/FR2003/001480
(87) Numéro de publication internationale: WO 2003/097905

(56) Documents cités:
- EP-A- 0 554 047
- WO-A-97/13012
- US-A- 5 989 340
- US-A- 6 056 820
- US-A1- 2001 004 877
- PATENT ABSTRACTS OF JAPAN vol. 017, no. 055 (C-1023), 3 février 1993 (1993-02-03) & JP 04 265294 A (TOSHIBA CORP), 21 septembre 1992 (1992-09-21)

## Description

La présente invention concerne un procédé et un dispositif de formation sous forme monocristalline d'un corps composé à évaporation non congruente susceptible d'exister sous forme monocristalline ou polycristalline. La suite de la description s'appliquera, à titre d'exemple, à la formation de carbure de silicium monocristallin, SiC.

L'invention s'applique en particulier à la réalisation de lingots ou de couches épaisses de SiC monocristallin d'un type de cristallisation, par exemple, cubique ou hexagonal. De tels lingots ou couches épaisses peuvent être utilisés pour la fabrication de substrats ou de couches actives utilisables en microélectronique. Pour de telles utilisations, le SiC monocristallin doit présenter une bonne qualité cristalline et un taux de dopants parfaitement contrôlé.

Un premier procédé connu, pour la fabrication de lingots de SiC monocristallin de qualité électronique, est basé sur la sublimation d'une poudre de SiC et la condensation des vapeurs formées sur un germe de SiC monocristallin. Un dispositif pour la mise en oeuvre d'un tel procédé comporte généralement un creuset en graphite qui définit une enceinte de sublimation dans laquelle sont disposés le germe monocristallin à partir duquel on souhaite former un lingot de SiC et la poudre de SiC qui constitue la source de SiC. La poudre de SiC et le germe sont respectivement chauffés à des températures T₁ et T₂ telles que T₁ soit supérieure à T₂.

Le procédé de sublimation précédemment décrit présente certains inconvénients.

En effet, malgré une préparation aussi méticuleuse que possible, les impuretés contenues dans la poudre de SiC sont à l'origine de défauts et de dopages indésirables du monocristal obtenu.

De plus, le procédé de sublimation ne permet pas la croissance de cristaux monocristallins de grande taille du fait de la quantité de poudre nécessairement limitée constituant la source de SiC. En effet, il est en pratique impossible d'alimenter le creuset en poudre de SiC de façon continue sans perturber excessivement les conditions de croissance du SiC monocristallin. De plus, il n'est pas non plus possible de disposer une grande quantité de poudre dans le creuset. En effet, la sublimation du SiC n'est pas congruente et il apparaît qu'une quantité plus importante de silicium que de carbone est produite lors de la sublimation de la poudre. La poudre tend donc à se charger en carbone. On obtient finalement, au fur et à mesure du déroulement du procédé, une modification de la composition de la poudre et des vapeurs issues de la sublimation, et par conséquent une modification des conditions de croissance du monocristal.

Un second procédé de fabrication de lingots de SiC monocristallin consiste en un dépôt en phase vapeur à très haute température (HTCVD) de SiC sur un germe de SiC monocristallin. Dans un creuset semblable à celui décrit pour le procédé de sublimation, des précurseurs gazeux du silicium et du carbone, par exemple du silane et du propane, sont envoyés, éventuellement à l'aide d'un gaz vecteur, sur le germe et réagissent pour former sur le germe un dépôt de SiC monocristallin. Le procédé de dépôt en phase vapeur est également utilisé pour la réalisation de couches actives.

Le principal inconvénient du procédé de dépôt en phase vapeur réside dans l'extrême difficulté à contrôler la croissance du lingot monocristallin, notamment à cause des mouvements turbulents des précurseurs gazeux.

De plus, pour la réalisation de couches actives, le procédé de dépôt en phase vapeur ne permet pas de dépasser des vitesses de dépôt de l'ordre de deux ou trois dizaines de micromètres par heure.

Les documents EP-A-0554047 et WO-A-97/13012 enseignent des dispositifs et procédés pour la formation de carbure de silicium monocristallin selon une méthode à deux étapes, c'est-à-dire une étape de CVD pour former la source de SiC suivie d'une étape de sublimation de cette source pour former le SiC monocristallin.

La présente invention vise à obtenir un procédé de formation de SiC monocristallin sur un germe de SiC monocristallin ne présentant pas les inconvénients des procédés précédemment décrits.

La présente invention vise également à obtenir un dispositif pour la fabrication de couches actives pouvant atteindre une épaisseur supérieure à quelques dizaines de micromètres ou de lingots de SiC monocristallin.

Pour atteindre ces objets, la présente invention prévoit un dispositif de formation à l'état monocristallin d'un corps composé à évaporation non congruente, susceptible d'exister sous forme monocristalline ou polycristalline, comportant une première enceinte contenant un substrat au niveau duquel est formée une source polycristalline dudit corps et un germe monocristallin dudit corps ; une seconde enceinte, ledit substrat étant disposé entre les deux enceintes ; des moyens d'apport de précurseurs gazeux dudit corps dans la seconde enceinte propres à provoquer le dépôt dudit corps sous forme polycristalline sur le substrat ; et des moyens de chauffage pour maintenir le substrat à une température supérieure à la température du germe de façon à provoquer la sublimation de la source polycristalline et le dépôt sur le germe dudit corps sous forme monocristalline.

Selon un mode de réalisation de l'invention, ledit corps est du carbure de silicium.

Selon un mode de réalisation de l'invention, la première enceinte est définie par une première paroi cylindrique, un couvercle, sur lequel est fixé le germe, recouvrant au moins en partie une extrémité de la première paroi, et le substrat recouvrant au moins en partie l'extrémité opposée de la première paroi, ledit substrat étant perméable.

Selon un mode de réalisation de l'invention, la seconde enceinte est définie par une seconde paroi cylindrique disposée dans le prolongement de la première paroi cylindrique du côté du substrat. Les première et seconde parois cylindriques sont entourées par un tube qui délimite avec les première et seconde parois cylindriques un évidement tubulaire, la seconde enceinte communiquant avec ledit évidement tubulaire.

Selon un mode de réalisation de l'invention, le dispositif comprend des moyens pour produire un écoulement gazeux dans l'évidement tubulaire pour évacuer les gaz présents dans la seconde enceinte.

Selon un mode de réalisation de l'invention, les moyens de chauffage comprennent au moins une spire d'induction entourant le tube et traversée par un courant alternatif de façon à induire des courants d'induction uniquement dans le tube.

Selon un mode de réalisation de l'invention, le couvercle est monté mobile en translation par rapport à la première paroi cylindrique selon l'axe de la première paroi cylindrique.

La présente invention prévoit également un procédé de formation à l'état monocristallin d'un corps composé à évaporation non congruente susceptible d'exister sous forme monocristalline ou polycristalline, comprenant les étapes réalisées simultanément consistant à former sur un substrat perméable, disposé entre des première et seconde enceintes, une source dudit corps sous forme polycristalline par dépôt sous phase vapeur de précurseurs gazeux dudit corps alimentant la seconde enceinte ; former dans la première enceinte des corps gazeux par sublimation d'une partie de la source ; et former ledit corps sous forme monocristalline par condensation des corps gazeux sur un germe disposé dans la première enceinte.

Selon un mode de réalisation de l'invention, le germe est éloigné du substrat au fur et à mesure de la formation du carbure de silicium monocristallin.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un écorché d'un dispositif de fabrication de lingots ou de couches épaisses de SiC monocristallin selon l'invention ; et
la figure 2 représente un écorché d'une variante du dispositif de la figure 1.

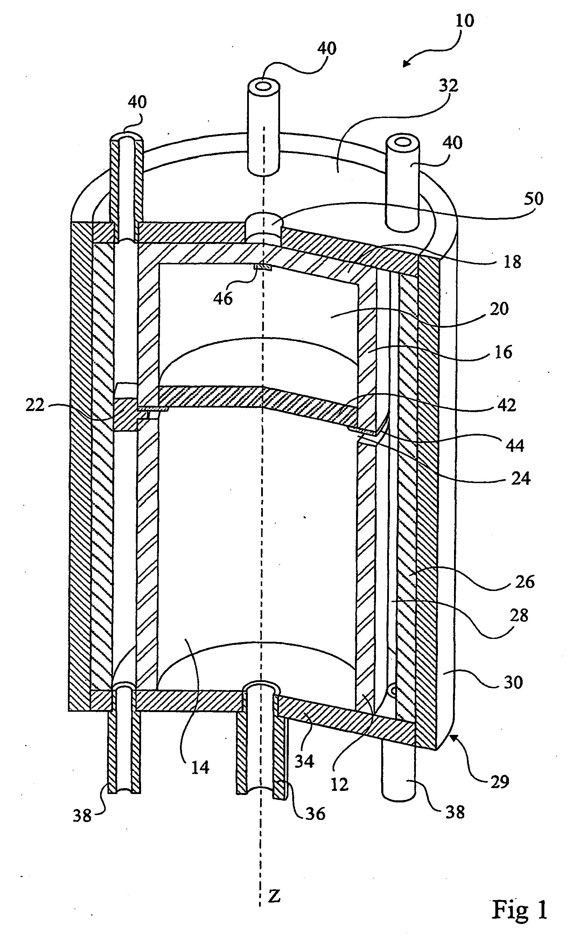

La figure 1 représente un dispositif 10 constitué d'une première paroi cylindrique 12 en graphite d'axe Z délimitant une première enceinte 14 appelée par la suite enceinte d'alimentation. Une seconde paroi cylindrique 16 en graphite d'axe Z, par exemple de même diamètre que la première paroi cylindrique 12 et fermée à une extrémité par un couvercle 18 solidaire de la paroi cylindrique 16, délimite une seconde enceinte 20, appelée par la suite enceinte de sublimation. La seconde paroi cylindrique 16 est disposée dans le prolongement de la première paroi cylindrique 12 et est séparée de celle-ci par des entretoises 22, une seule entretoise étant représentée sur la figure 1. Les entretoises 22 délimitent un passage 24 sensiblement annulaire entre les deux enceintes 14, 20. L'axe Z correspond par exemple à l'axe vertical, l'enceinte de sublimation 20 étant disposée au-dessus de l'enceinte d'alimentation 14.

Un tube cylindrique 26 en graphite d'axe Z entoure les deux parois cylindriques 12, 16 et délimite avec celles-ci un évidement tubulaire 28.

Les deux enceintes 14, 20 sont enfermées dans un boîtier isolant 29 en feutre graphite constitué d'une paroi cylindrique 30 d'axe Z disposée autour du tube 26 et fermée aux deux extrémités par des plaques sensiblement circulaires 32, 34.

Un conduit d'alimentation en gaz 36 communique avec l'enceinte d'alimentation 14 au travers de la plaque 34. Des conduites d'apport 38 d'un gaz neutre communiquent avec l'évidement tubulaire 28 au travers de la plaque 34 du côté de l'enceinte d'alimentation 14. Des conduites d'évacuation 40 de gaz communiquent avec l'évidement tubulaire 28 au travers de la plaque 32.

Un substrat 42 circulaire, par exemple en mousse poreuse de carbone ou en SiC fritté, est posé sur une rondelle 44 maintenue contre la paroi cylindrique 16 par les entretoises 22. Le diamètre du substrat 42 correspond par exemple sensiblement au diamètre intérieur de la paroi cylindrique 16. Le diamètre du substrat 42 peut toutefois être inférieur au diamètre intérieur de la paroi cylindrique 16, et l'enceinte d'alimentation 14 peut éventuellement communiquer partiellement directement avec l'enceinte de sublimation 20. Le substrat 42 sépare l'enceinte de sublimation 20 de l'enceinte d'alimentation 14. Le substrat 42 est perméable aux gaz issus de la sublimation du SiC ou au moins permet une diffusion à travers celui-ci du SiC polycristallin.

Un germe 46 de carbure de silicium monocristallin est disposé dans l'enceinte de sublimation 20 sur le couvercle 18. Une ouverture 50 est réalisée dans la plaque circulaire 32 et découvre une portion du couvercle 18 au niveau du germe 46.

Des spires d'induction, non représentées, entourent la paroi cylindrique 30 du boîtier isolant 29 sensiblement au niveau du substrat 42. La fréquence du courant alimentant les spires d'induction est telle que seul le tube 26 est traversé par des courants induits. La répartition des températures dans les enceintes 14, 20 chauffées par le tube 26 est alors sensiblement indépendante des matériaux présents dans les enceintes 14, 20 et par conséquent des phénomènes chimiques ayant lieu dans les enceintes 14 et 20.

Le procédé de fabrication de SiC selon l'invention est le suivant.

Le dispositif 10 est placé dans une chambre sous un vide partiel, ou en atmosphère inerte pour prévenir toute réaction de combustion du graphite constituant le dispositif. On impose à l'intérieur de l'enceinte de sublimation 20 un gradient de température entre le substrat 42 et le germe 46 tel que la température T₁ du substrat 42 soit supérieure à la température T₂ du germe 46. La température T₁ est par exemple comprise entre 2000°C et 2400°C, et la température T₂ est par exemple comprise entre 1900°C et 2200°C. Le boîtier isolant 29 limite les pertes de chaleur. L'ouverture 50 dans le boîtier isolant 29 favorise la baisse de température du germe 46.

Un écoulement d'un gaz neutre, tel que l'argon, est réalisé dans l'évidement tubulaire 28 entre les conduites d'apport 38 et les conduites d'évacuation 40. Un tel écoulement tend à entraîner les gaz présents dans l'enceinte d'alimentation 14 par le passage 24 et à les diluer.

Au moyen du conduit d'alimentation 36, des précurseurs gazeux du silicium et du carbone réagissant à haute température sont introduits dans l'enceinte d'alimentation 14 et dirigés vers le substrat 42. Les précurseurs gazeux sont éventuellement mélangés à un ou plusieurs gaz vecteurs, par exemple de l'argon ou de l'hydrogène. Les précurseurs gazeux, par exemple du silane, du propane ou des gaz à base chlorée par exemple du SiCl₄, réagissent à très haute température pour former du SiC polycristallin sur le substrat 42. Les précurseurs gazeux, ayant totalement ou partiellement réagi, et les gaz vecteur sont ensuite évacués de l'enceinte d'alimentation 14 par l'intermédiaire du passage 24 et entraînés et dilués dans l'évidement tubulaire 28 par l'écoulement de gaz neutres.

Le SiC polycristallin formé sur le substrat 42 se sublime pour former dans l'enceinte de sublimation 20 des espèces gazeuses qui se condensent alors sur le germe 46 monocristallin pour faire croître du SiC monocristallin.

Le présent procédé permet la réalisation de lingots ou de couches épaisses de SiC monocristallin à des taux de croissance supérieurs à 50 µm/heure et pouvant atteindre et dépasser 1 mm/heure.

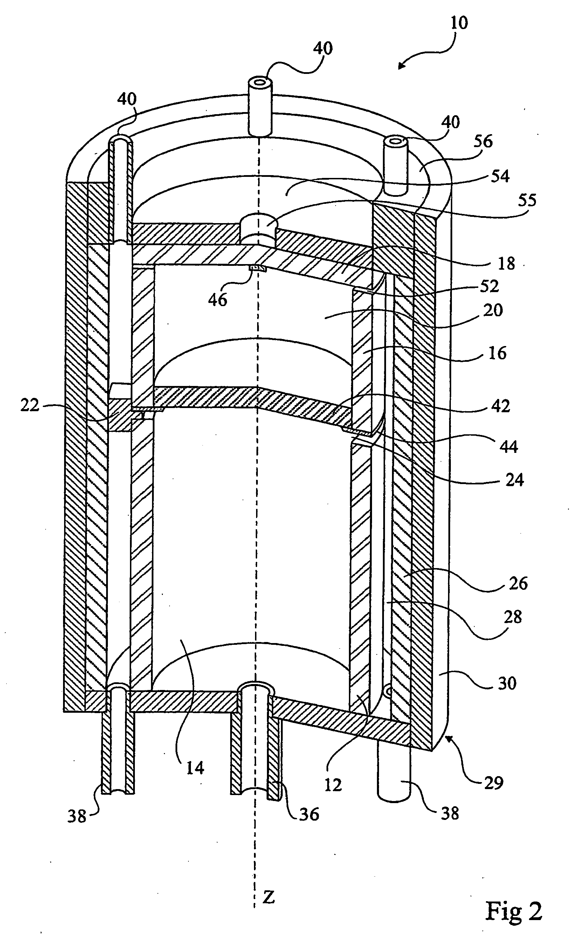

La figure 2 représente une variante du dispositif 10 de la figure 1 dans lequel le couvercle 18 est mobile selon l'axe Z. Une ouverture annulaire 52 sépare alors le couvercle 18 de la paroi cylindrique 16.

Une plaque circulaire 54 en feutre graphite recouvre le couvercle 18, et comprend une ouverture 55 réalisée au niveau du germe 46. Un anneau 56 d'axe Z en feutre graphite referme l'évidement tubulaire 28 entre la paroi cylindrique 30 et la plaque circulaire 54. Le couvercle 18 et la plaque circulaire 54 peuvent être déplacés en translation selon l'axe Z par des actionneurs non représentés de façon à être éloignés du substrat 42.

Le dispositif 10 selon la variante permet de réaliser des lingots ou des couches épaisses de SiC monocristallin de grandes épaisseurs selon l'axe Z. En effet, en éloignant le couvercle 18 du substrat 42 à une vitesse sensiblement égale à la vitesse de croissance du SiC monocristallin, on peut maintenir à peu près constant la distance séparant le substrat de la surface libre du SiC monocristallin formé. Les lingots ou les couches de SiC monocristallin obtenus peuvent atteindre une épaisseur selon l'axe Z supérieure à 50 mm. Au fur et à mesure que le couvercle 18 se déplace, l'ouverture 52 tend à s'agrandir. La demanderesse a mis en évidence que les turbulences gazeuses produites par l'ouverture 52 perturbent peu la croissance du SiC monocristallin.

Selon une autre variante de l'invention, l'enceinte de sublimation est formée par une paroi cylindrique principale dans laquelle peut coulisser une paroi cylindrique complémentaire. La paroi cylindrique principale est ouverte aux deux extrémités et est séparée de l'enceinte d'alimentation par le substrat. La paroi cylindrique complémentaire est ouverte à une extrémité et fermée à une extrémité par un couvercle portant le germe. La distance entre le germe et le substrat peut être ajustée par le coulissement de la paroi complémentaire par rapport à la paroi principale. La présente variante permet de limiter les perturbations gazeuses dans l'enceinte de sublimation.

La présente invention présente de nombreux avantages.

Premièrement, elle permet de former du SiC monocristallin par une étape de sublimation d'une source de SiC polycristallin qui peut être renouvelée en continu. Elle permet ainsi de réaliser des lingots ou des couches épaisses de grandes dimensions avec des taux de croissance élevés caractéristiques d'un procédé de formation par sublimation.

Deuxièmement, la constitution de deux enceintes, chacune étant dédiée de façon privilégiée à un certain type de réaction, d'une part le dépôt de SiC polycristallin sous phase vapeur et d'autre part la sublimation de la source polycristalline, permet de renouveler de façon continue la source de SiC polycristallin sans perturber la croissance du SiC monocristallin. On peut ainsi obtenir du SiC monocristallin de bonne qualité cristalline.

Troisièmement, la présente invention permet la constitution d'une source de carbure de silicium polycristallin de très haute pureté puisque les précurseurs gazeux utilisés pour le dépôt sous phase vapeur peuvent être facilement purifiés. Le SiC monocristallin obtenu peut donc être de très haute pureté. On peut ainsi éventuellement contrôler très précisément le dopage du SiC monocristallin par l'introduction de dopants dans les précurseurs gazeux.

Bien entendu, la présente invention est susceptible de diverses variantes et modifications qui apparaîtront à l'homme de l'art. En particulier, la forme et les dimensions du four sont à adapter en fonction des lingots ou couches épaisses de SiC monocristallin à obtenir. En outre, le dispositif de chauffage selon l'invention peut être utilisé pour la formation de composés monocristallins autres que le SiC. Il peut s'agir par exemple de nitrure d'aluminium utilisé notamment pour des applications en optoélectronique.

## Revendications

1. Dispositif (10) de formation à l'état monocristallin d'un corps composé à évaporation non congruente, susceptible d'exister sous forme monocristalline ou polycristalline, comportant :
- une première enceinte (20) contenant un germe (46) monocristallin dudit corps ;
- une seconde enceinte (14) ;
- un substrat (42) au niveau duquel est formée une source polycristalline dudit corps, ledit substrat étant disposé entre les deux enceintes et séparant la seconde enceinte de la première enceinte ;
- des moyens d'apport (36) de précurseurs gazeux dudit corps dans la seconde enceinte propres à provoquer le dépôt dudit corps sous forme polycristalline sur le substrat ; et
- des moyens de chauffage (26) pour maintenir le substrat à une température supérieure à la température du germe de façon à provoquer la sublimation de la source polycristalline et le dépôt sur le germe dudit corps sous forme monocristalline, le substrat étant perméable aux gaz issus de la sublimation de la source polycristralline ou au moins permettant la diffusion à travers celui-ci de la source polycristalline.

2. Dispositif selon la revendication 1, **caractérisé en ce que** ledit corps est du carbure de silicium.

3. Dispositif selon la revendication 1, **caractérisé en ce que** la première enceinte (20) est définie par une première paroi cylindrique (16), un couvercle (18), sur lequel est fixé le germe (46), recouvrant au moins en partie une extrémité de la première paroi, et le substrat (42) recouvrant au moins en partie l'extrémité opposée de la première paroi, ledit substrat étant perméable.

4. Dispositif selon la revendication 3, **caractérisé en ce que** la seconde enceinte (14) est définie par une seconde paroi cylindrique (12) disposée dans le prolongement de la première paroi cylindrique (16) du côté du substrat (42), et **en ce que** les première (16) et seconde (12) parois cylindriques sont entourées par un tube (26) qui délimite avec les première et seconde parois cylindriques un évidement tubulaire (28), la seconde enceinte (14) communiquant avec ledit évidement tubulaire.

5. Dispositif selon la revendication 4, **caractérisé en ce qu'**il comprend des moyens (38, 40) pour produire un écoulement gazeux dans l'évidement tubulaire (28) pour évacuer les gaz présents dans la seconde enceinte (14).

6. Dispositif selon la revendication 5, **caractérisé en ce que** les moyens de chauffage (26) comprennent au moins une spire d'induction entourant le tube (26) et traversée par un courant alternatif de façon à induire des courants d'induction uniquement dans le tube.

7. Dispositif selon la revendication 3, **caractérisé en ce que** le couvercle (18) est monté mobile en translation par rapport à la première paroi cylindrique (16) selon l'axe (Z) de la première paroi cylindrique.

8. Procédé de formation à l'état monocristallin d'un corps composé à évaporation non congruente susceptible d'exister sous forme monocristalline ou polycristalline, **caractérisé en ce qu'**il comprend les étapes suivantes réalisées simultanément :
- former sur un substrat (42) disposé entre des première (20) et seconde (14) enceintes et séparant la seconde enceinte de la première enceinte, une source dudit corps sous forme polycristalline par dépôt sous phase vapeur de précurseurs gazeux dudit corps alimentant la seconde enceinte, le substrat étant perméable aux gaz issus de la sublimation de la source polycristralline ou au moins permettant la diffusion à travers celui-ci de la source polycristalline ;
- former dans la première enceinte des corps gazeux par sublimation d'une partie de la source ; et
- former ledit corps sous forme monocristalline par condensation des corps gazeux sur un germe (46) disposé dans la première enceinte.

9. Procédé selon la revendication 8, **caractérisé en ce que** ledit corps est du carbure de silicium.

10. Procédé selon la revendication 8, **caractérisé en ce que** le germe (46) est éloigné du substrat (42) au fur et à mesure de la formation du carbure de silicium monocristallin.

## Claims

1. A device (10) for forming in the single-crystal state a compound, having an incongruent evaporation and existing in single-crystal or polycrystalline form, comprising:
- a first enclosure (20) containing a single-crystal germ (46) of said compound;
- a second enclosure (14),
- a substrate (42) at the level of which is formed a polycrystalline source of said compound said substrate being arranged between the two enclosures and separating the second enclosure from the first enclosure;
- means (36) for supplying gas precursors of said compound into the second enclosure capable of causing the deposition of said compound in polycrystalline form on the substrate; and
- heating means (26) for maintaining the substrate at a temperature greater than the germ temperature to cause the sublimation of the polycrystalline source and the deposition on the germ of said compound in single-crystal form, the substrate being permeable to the gases originating from the sublimation of the polycrystalline source or, at least, authorizing the diffusion therethrough of the polycrystalline source.

2. The device of claim 1, **characterized in that** said compound is silicon carbide.

3. The device of claim 1, **characterized in that** the first enclosure (20) is defined by a first cylindrical wall (16), a cover (18), on which the germ (46) is attached, at least partly covering one end of the first wall, and the substrate (42) at least partly covering the opposite end of the first wall, said substrate being permeable.

4. The device of claim 3, **characterized in that** the second enclosure (14) is defined by a second cylindrical wall (12) arranged in prolongation of the first cylindrical wall (16) on the side of the substrate (42), and the first (16) and second (12) cylindrical walls are surrounded with a tube (26) which delimits with the first and second cylindrical walls a tubular recess (28), the second enclosure (14) communicating with said tubular recess.

5. The device of claim 4, **characterized in that** it comprises means (38, 40) for generating a gas flow in the tubular recess (28) to exhaust the gases present in the second enclosure (14).

6. The device of claim 5, **characterized in that** the heating means (26) comprise at least one induction spiral surrounding the tube (26) and conducting an A.C. current to induce induction currents in the tube only.

7. The device of claim 3, **characterized in that** the cover (18) is shiftably assembled with respect to the first cylindrical wall (16) along the axis (Z) of the first cylindrical wall.

8. A method for forming in the single-crystal state a compound having an incongruent evaporation and existing in single-crystal or polycrystalline form, comprising the simultaneously performed steps of:
- forming on a substrate (42), arranged between first (20) and second (14) enclosures and separating the second enclosure from the first enclosure, a source of said compound in polycrystalline form by chemical vapor deposition of gas precursors of said compound supplying the second enclosure, the substrate being permeable to the gases originating from the sublimation of the polycrystalline source or, at least, authorizing the diffusion therethrough of the polycrystalline source;
- forming in the first enclosure gaseous compounds by sublimation of a portion of the source; and
- forming said compound in single-crystal form by condensation of the gaseous compounds on a germ (46) arranged in the first enclosure.

9. The method of claim 8, **characterized in that** said compound is silicon carbide.

10. The method of claim 8, **characterized in that** the germ (46) is moved away from the substrate (42) along the forming of the single-crystal silicon carbide.

## Patentansprüche

1. Vorrichtung (10) zum Formen einer monokristallinen Verbindung mit inkongruenter Verdampfung, die in monokristalliner oder polykristallliner Form existieren kann, welche Folgendes aufweist:
eine erste Umhüllung (20), die einen monokristallinen Keim (46) der Verbindung enthält;
eine zweite Umhüllung (14);
ein Substrat (42), auf dessen Niveau eine polykristalline Quelle der Verbindung gebildet wird, wobei das Substrat zwischen den zwei Umhüllungen angeordnet ist und die zweite Umhüllung von der ersten Umhüllung trennt;
Mittel (36) zum Liefern von gasförmigen Präkursoren (Vorstoffen) der Verbindung in die zweite Umhüllung, die die Ablagerung der Verbindung in polykristalliner Form auf dem Substrat bewirken können; und
Heizungsmittel (26) zum Halten des Substrates auf einer größeren Temperatur als der Keimtemperatur, um die Sublimation der polykristallinen Quelle und die Ablagerung an dem Keim der Verbindung in monokristalliner Form zu bewirken, wobei das Substrat für die Gase durchlässig ist, die aus der Sublimation der polykristallinen Quelle herrühren, oder zumindest eine Diffusion der polykristallinen Quelle dort hindurch gestatten.

2. Vorrichtung nach Anspruch 1, **dadurch gekennzeichnet, dass** die Verbindung Siliziumcarbid ist.

3. Vorrichtung nach Anspruch 1, **dadurch gekennzeichnet, dass** die erste Umhüllung (20) durch eine erste zylindrische Wand (16), eine Abdeckung (18), an der der Keim (46) angebracht ist, die zumindest teilweise ein Ende der ersten Wand bedeckt, und das Substrat (42) definiert ist, welches zumindest teilweise das gegenüberliegende Ende der ersten Wand abdeckt, wobei das Substrat permeabel bzw. durchlässig ist.

4. Vorrichtung nach Anspruch 3, **dadurch gekennzeichnet, dass** die zweite Umhüllung (14) durch eine zweite zylindrische Wand (12) definiert wird, die als Verlängerung der ersten zylindrischen Wand (16) auf der Seite des Substrates (42) angeordnet ist, und wobei die erste zylindrische Wand (16) und die zweite zylindrische Wand (12) mit einem Rohr (26) umgeben sind, welches mit den ersten und zweiten zylindrischen Wänden eine rohrförmige Ausnehmung (28) begrenzt, wobei die zweite Umhüllung (14) mit der rohrförmigen Ausnehmung in Verbindung ist.

5. Vorrichtung nach Anspruch 4, **dadurch gekennzeichnet, dass** sie Mittel (38, 40) aufweist zur Erzeugung eines Gasflusses in der rohrförmigen Ausnehmung (28), um das in der zweiten Umhüllung (14) vorhandene Gas abzuleiten.

6. Vorrichtung nach Anspruch 5, **dadurch gekennzeichnet, dass** die Heizungsmittel (26) mindestens eine Induktionsspirale aufweisen, die das Rohr (26) umgibt und einen Wechselstrom derart leitet, um Induktionsströme nur in dem Rohr zu induzieren.

7. Vorrichtung nach Anspruch 3, **dadurch gekennzeichnet, dass** die Abdeckung (18) verschiebbar bezüglich der ersten zylindrischen Wand (16) entlang der Achse (Z) der ersten zylindrischen Wand angeordnet ist.

8. Verfahren zum Formen einer Verbindung im monokristallinen Zustand mit einer inkongruenten Verdampfung, die in monokristalliner oder polykristalliner Form existieren kann, welches die folgenden gleichzeitig ausgeführten Schritte aufweist:
Formen einer Quelle der Verbindung in polykristalliner Form auf einem Substrat (42), welches zwischen einer ersten Umhüllung (20) und einer zweiten Umhüllung (14) angeordnet ist und die zweite Umhüllung von der ersten Umhüllung trennt, und zwar durch chemische Dampfablagerung von gasförmigen Präkursoren der Verbindung, die in die zweite Umhüllung geliefert werden, wobei das Substrat für die Gase durchlässig ist, die von der Sublimation der polykristallinen Quelle herrühren, oder wobei es zumindest teilweise eine Diffusion der polykristallinen Quelle dort hindurch gestattet,
Formen von gasförmigen Verbindungen in der ersten Umhüllung durch Sublimation eines Teils der Quelle; und
Formen der Verbindung in monokristalliner Form durch Kondensation der gasförmigen Verbindungen an einem Keim (46), der in der ersten Umhüllung angeordnet ist.

9. Verfahren nach Anspruch 8, **dadurch gekennzeichnet, dass** die Verbindung Siliziumcarbid ist.

10. Verfahren nach Anspruch 8, **dadurch gekennzeichnet, dass** der Keim (46) vom Substrat (42) während der Formgebung des monokristallinen Siliziumcarbids wegbewegt wird.
